# EUROPEAN PATENT APPLICATION

(11) **EP 0 860 950 A2**
(43) Date of publication of application: **26.08.1998**
(21) Application number: 98102769.1
(22) Date of filing: 18.02.1998
(51) Int. Cl.: H03M 1/06

(54) **Digital-to-analog data converter with internal reference and method of operation thereof**

(30) Priority: 21.02.1997 US 804206
(71) Applicant: MOTOROLA, INC., Schaumburg, IL 60196 (US)
(72) Inventor: Cave, Michael D., Pflugerville, Texas, 78660 (US); Westwick, Alan L., Austin, Texas, 78746 (US); Zavaleta, Mauricio, Austin, Texas 78746 (US); Barker, Todd, Chicago, Illinois 60647 (US)
(74) Representative: Gibson, Sarah Jane

(57) **Abstract**

A data converter (10) includes an operational amplifier (14), a first reference input element (18), a second reference input element (22), voltage references 40, and a control element (34). The control element (34) generates control signals (36, 38) based on a digital input. The first reference input element (18) provides a sampled first reference signal (16) to a first input node (13), the sampling of the first temperature variant signal being based on the control signals. The second reference input element (22) provides a sampled difference of the second and third reference signals (20 & 21) to the first input node, the sampling of the second and third temperature variant signals being based on the control signals. The operational amplifier (14) integrates the inputs to perform a digital-to-analog conversion that is substantially temperature invariant.

## Description

### Cross-reference to Related Application

The present application is related to U.S. patent 5,633,640 assigned to Motorola, Inc.

### Technical Field of the Invention

The present invention relates generally to data conversion circuitry and more particularly to a data converter having integrated reference circuitry.

### Background of the Invention

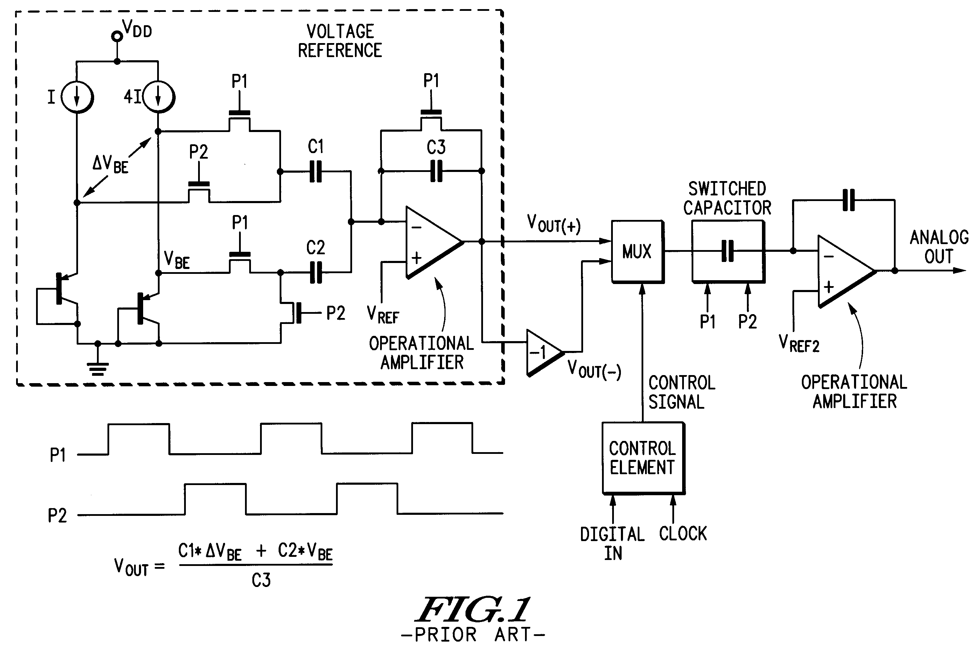

As is known, data conversion circuitry converts digital signals into analog signals. The digital-to-analog conversion may be accomplished by a variety of circuits. FIG. 1 illustrates a single-stage, single-bit, digital-to-analog converter for a sigma-delta converter. In the first stage of the converter, a voltage reference signal (Vₒᵤₜ or -Vₒᵤₜ) is selected at a multiplexer by a control signal corresponding to an incoming digital signal (DIGITAL IN) and a clock (CLOCK). The selected reference voltage is sampled by a switched capacitor, and the resulting sampled signal then serves as an input to an integrating operational amplifier, which integrates the sampled signal to produce the output analog signal (ANALOG OUT).
As is known in the art, a variety of circuits and techniques may be used to convert a digital input signal to an equivalent analog output signal, each with its relative benefits and drawbacks. While the converter illustrated in FIG. 1 is a single bit converter, the conversion technique may be expanded to multiple-bit conversion processes and other processes. A common requirement among all of the processes, however, is the requirement of a voltage reference of a fixed voltage level that is selectively sampled. In order for the data conversion circuitry to perform optimally, the voltage reference must be noise free and temperature invariant.

A circuit commonly used to produce a temperature invariant voltage reference is also illustrated in FIG. 1 and occupies the upper left hand portion of FIG. 1 and is designated as a voltage reference. The circuit includes two current-driven bipolar transistors, a switched capacitor network, and a summing amplifier. The bipolar transistors, driven at two different current densities, produce differing base-to-emitter voltages (V_{BE}). Because the base-to-emitter voltage exhibits a negative temperature coefficient and the difference between the base-to-emitter voltages of the transistors _V_{BE} exhibits a positive temperature coefficient, the signals may be selectively combined to produce a temperature invariant voltage reference. As illustrated in FIG. 1, a switched capacitor array and a summing amplifier may be employed to produce the temperature invariant voltage reference (referred to as Vₒᵤₜ) according to the equation shown.

A shortcoming of the standard temperature invariant voltage reference circuitry relates to the circuit components used. The voltage reference circuitry requires both a switched capacitor network and a summing amplifier to create the temperature invariant voltage reference. These components not only require additional components on the chip but add complexity, consume power, and generate additional heat.

Further, in a typical integrated circuit that includes an A/D converter, the voltage reference circuitry resides at a location removed from the A/D converter. Thus, noise couples onto the voltage reference transmission path and resultantly becomes a part of the voltage reference. Noise in the voltage reference negatively affects the performance of the conversion process. Therefore, a large external bypass capacitor is usually employed to reduce the noise on the voltage reference. The external bypass capacitor also improves the power supply rejection ratio of the converter. Unfortunately, two pin-outs must be added to the chip and additional footprint area is needed to accommodate the bypass capacitor.

Still further, by examining the circuit of FIG. 1, it can be seen that for a single stage sigma-delta converter, two operational amplifiers are needed-one for the voltage reference and a second for the data converter section. Once again, by utilizing the circuit of FIG. 1, additional components are needed which has the above mentioned drawbacks.

Therefore, a need exists for a converter that reduces component count, reduces complexity, reduces power consumption, and eliminates the need for the external pins to filter noise from the voltage reference while still providing a reliable digital-to-analog conversion.

### Brief Description of the Drawings

FIG. 1 illustrates a conventional single-stage, single-bit, digital-to-analog converter for a sigma-delta converter.
FIG. 2 illustrates a schematic block diagram of a preferred embodiment of a data converter in accordance with the present invention;
FIG. 3 illustrates a logic flow diagram that may be used to control a converter, in accordance with a preferred embodiment of the present invention.

### Detailed Description of a Preferred Embodiment

Generally, the present invention provides an apparatus and method for converting digital data into analog data via a data converter having an internal reference, and that, for a first order converter, includes a single operational amplifier. This may be accomplished by combining, in a controlled manner, a plurality of temperature variant reference voltages at the input of an integrating operational amplifier, as a function of the digital input signal. The combining of the temperature variant signals is controlled by a controlling element, wherein the controlling element generates a control signal based on a clock signal and a digital input signal of the data converter.

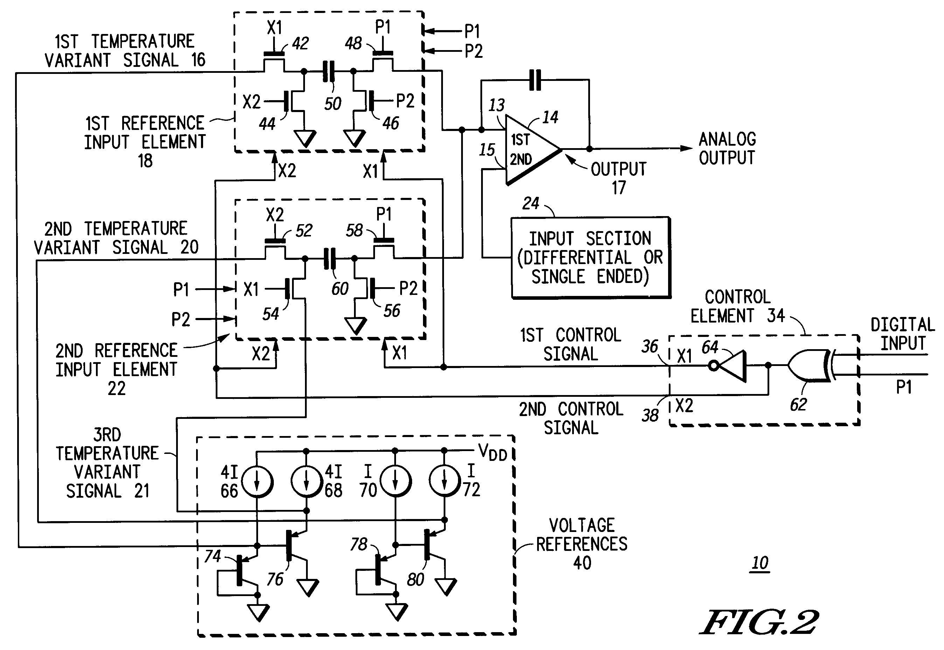

FIG. 2 illustrates a schematic block diagram of a data converter 10 which comprises an operational amplifier 14, a first reference input element 18, a second reference input element 22, a control element 34, and voltage references 40. The converter 10 operates in a sigma-delta mode to convert a digital input signal (DIGITAL INPUT) to an analog output signal (ANALOG OUTPUT) at an output 17 of the operational amplifier 14. While the converter illustrated in FIG. 2 is a single bit converter, the conversion technique may be expanded to multiple-bit conversion processes and other processes.

The operational amplifier 14 includes a capacitor connected from an output 17 to the first input node 13, thus causing the operational amplifier 14 to perform an integration (or filtering) function on the signals presented to inputs 13 and 15. The signal present at the second input node 15 may be a reference voltage for single-ended operation or an equivalent input section as that coupled to the first input node 13 for differential operation. To further illustrate the signal present at the second input node 15, the second input node may be coupled to an input section 24 which provides the single-ended mode or the differential mode of operation. In the single-ended mode, the input section 24 connects the second terminal 15 to an analog reference voltage. The reference voltage could be chosen to be ground, one-half of a supply voltage level, or at another fixed level. When the input section 24 is providing the differential mode, the second terminal 15 connects to a differential circuit. The differential circuit (not shown) is substantially identical to the circuitry that is coupled to the first input node 13. In the differential mode, the input signal presented to the operational amplifier 14 across the first input node 13 and second input 15 represents a difference between two voltages instead of a difference between a voltage at the first input node 13 and a ground reference. As one skilled in the art will readily appreciate, the differential mode connection functions to reduce noise in the converter 10 by preventing noise on the ground plane from serving as a component of a single ended reference. Connected differentially, any coupled noise tends to offset and cancel itself in the conversion process therefore resulting in less error due to noise.

The control element 34 produces control signals X1 36 and X2 38 that serve as inputs to the first reference input element 18, and the second reference input element 22. Control signals X1 36 and X2 38 are responsive to the DIGITAL INPUT as well as the clock signal P₁ (or alternatively P₂). Preferably, the control element 34 comprises an exclusive-OR gate 62 and an inverter 64. By utilizing P₁ as an input, signal X2 38 goes to a logic high level only when (1) the DIGITAL INPUT provides a logic high level or (2) when the clock signal P₁ is at a logic high level, but not when both are at a logic high level, with the control signal X1 36 being the complement of the control signal X2 38. As one skilled in the art will readily appreciate, however, the first reference input element 18 and the second reference input element 22 may be selectively controlled in any of a number of manners using clock signals P₁ and P₂ and control signals X1 36 and X2 38. Operation of switched capacitor arrays, such as those preferably contained within the first reference input element 18 and the second reference input element 22, is well known and will not be exhaustively discussed herein.

The first, second and third reference signals 16, 20, 21 are generated by a voltage reference circuit 40. The voltage reference circuit 40 comprises a plurality of bipolar transistors 74, 76, 78, 80 and a plurality of current sources 66, 68, 70, 72. As shown, current sources 66 and 68 provide a current to transistors 74 and 76, while current sources 70 and 72 provide a current to transistors 78 and 80, wherein the current provided by current sources 66 and 68 is four times the current provided by current sources 70 and 72. The first reference signal 16 is representative of the voltage at the emitter of transistor 74, the second reference signal 20 is representative of the voltage at the emitter of transistor 80, and the third reference signal 21 is representative of the voltage at the emitter of transistor 76. The first reference signal 16 is coupled to an input of switch 42, which is controlled by a first control signal X1, the second reference signal 20 is coupled to an input of switch 52, which is controlled by the second control signal X2 38, and the third reference signal 21 is coupled to the input of switch 54, which is controlled by the first control signal X1 36. It should be noted that the first, second and third reference signals are temperature variant signals.

The first reference input element 18 operably couples the temperature variant first reference signal 16 to a first input node 13 of the operational amplifier 14. The first reference input element 18 may be any device that has an impedance, wherein the impedance is based on the desired transfer function of the overall circuit. For example, the first reference input element 18 may be a resistor, a complex network, or a switched capacitor array that includes a capacitor 50 and four switches 42, 44, 46, and 48, as shown in FIG. 2. This switched capacitor is gated by a clock signal, which includes a first phase (P₁) and a second phase (P₂), wherein P₁ and P₂ are complementary and non-overlapping, and the first control signal X1 and the second control signal X2. While the switched capacitor array may be viewed simply as a charge transfer element, it may also be viewed as a resistive element. Viewed in either manner, the switched capacitor array couples the first reference signal 16 to the first input node 13.

The second reference input element 22 may be any device that has an impedance, wherein the impedance is based on the desired transfer function of the overall circuit. For example, the second reference input element 22 may be a resistor, a complex network, or a switched capacitor array that includes a capacitor 60 and four switches 52, 54, 56, and 58, as shown in fig. 2. Gating of the switched capacitor is controlled by the first and second phases of the clock signal P1 and P2 and a control signal that includes two phases X1 36 and X2 38, selectively connected between the element's input and output connections.

In order for the first reference signal 16, the second reference signal 20 and the third reference signal 21 to be different, the base-emitter voltages (V_{BE}) of transistor 74, transistor 76, transistor 78, and transistor 80 must be different. This can be accomplished by taking advantage of the current-to-V_{BE} relationship of bipolar transistors. For example, by choosing transistor 78 and transistor 80 to be four times as large as transistor 74 and transistor 76 respectively, transistors 78 and 80 have one-sixteenth the current density as transistors 74 and 76. The first reference signal 16 is generated as the V_{BE} of transistor 74 and is sampled on capacitor 50 by the clocking of switches 42, 44. With the base-to-emitter voltage across transistor 76 larger than that across transistor 80, a voltage difference (_V_{BE}) between the second and third signals 20 and 21 is sampled on capacitor 60 by the clocking of switches 52, 54. While the above described circuit produces different sampled voltages, this difference is not fixed because the base-to-emitter voltage signal V_{BE} exhibits a negative temperature coefficient and the differential signal _V_{BE} exhibits a positive temperature coefficient. Also, the particular preferred embodiment shown in FIG. 2 actually uses a voltage difference of 2_V_{BE}, not just _V_{BE}.

While the reference input elements 18 and 22 have similar construction, they do vary in their input connections. Thus, in operation, the first reference input element 18 operably couples, either adds or subtracts, the first reference signal 16 to, or from, the first input node 13 to provide a first temperature variant signal input to the operational amplifier. However, the second reference input element 22 either adds or subtracts the differential signal _V_{BE}, to or from, the first input node 13 to provide a second temperature variant signal input into the operational amplifier. The addition/subtraction of these voltage references coupled by the first reference input element 18 and the second reference input element 22 is dependent upon the control signals X1 36 and X2 38, which performs the digital to analog conversion through integration of the operational amplifier 14 output. By selectively inputting the reference voltages in the operation amplifier, converter 10 maintains its accuracy over a wide temperature range because the voltage references have different but opposite temperature coefficients. In other words, because the base-to-emitter voltage signal exhibits a negative temperature coefficient and the differential signal exhibits a positive temperature coefficient, the first temperature variant signal input into the operational amplifier and the second temperature variant signal input into the operational amplifier have complementary voltage variation as a function of temperature. The ratio of V_{BE} to _V_{BE} is set by the ratio of the value of capacitor 50 to the value of capacitor 60. By proper choice of this ratio, the overall temperature coefficient of the converter's output voltage can be set to zero.

As shown and described, the circuit of FIG. 2 includes, for a first order, or single stage, data converter, a single operational amplifier 14 which is used to integrate the input signals. By combining the reference voltages in the integrating operational amplifier as described, a separate operational amplifier to produce a voltage reference is not needed. Thus, the present invention reduces component count, reduces circuit complexity, and reduces power consumption. In addition, by converging the voltage reference with the components of the data converter, geographic separation of these circuits is eliminated, which, in turn, eliminates the need for an external filtering capacitor, and thus eliminates the need for two additional pin connections.

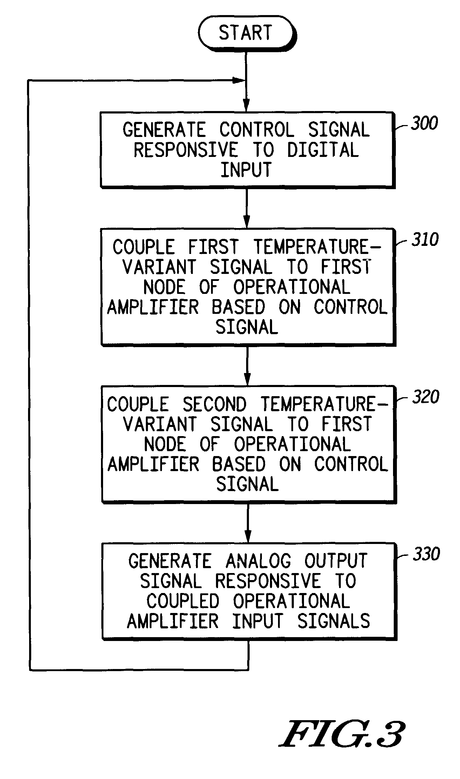

FIG. 3 illustrates a logic flow diagram that may be used to control a converter, in accordance with a preferred embodiment of the present invention. At step 300, a digital input signal is coupled to a control element that produces a control signal based on the digital signal. At step 310, a first temperature variant signal is coupled, based on the control signal, to a first input node of an operational amplifier. At step 320, a second temperature variant signal is coupled, based on the control signal, to the first input node of the operational amplifier. In preferred embodiments, the second temperature variant signal is sampled as a difference between a second and third reference signals. And at step 330, an analog output signal is generated at an output of the operational amplifier in response to the combination of the first and second temperature variant signals at the first input node, wherein the first temperature variant signal and the second temperature variant signal have complementary voltage variation as a function of temperature, resulting in the analog output signal being a function of the digital input and being substantially temperature invariant. The process then returns to step 300 to further generate control signals responsive to the digital input.

As can now be appreciated, a first order data converter having an internal reference for providing a reliable digital-to-analog conversion using a single operational amplifier is provided by the present embodiment, thereby reducing component count, reducing circuit complexity, reducing power consumption, and eliminating the need for voltage reference filtering pins in comparison with the prior art converter. The above described preferred embodiments are intended to illustrate the principles of the invention, but not to limit the scope of the invention. Various other embodiments and modifications to these preferred embodiments may be made by those skilled in the art without departing from the scope of the following claims. For example, in an alternative embodiment, the switched capacitors would be eliminated in a current-summing architecture having current sources for producing two or more temperature dependent currents that are combined at the op amp input to produce the substantially temperature invariant output.

## Claims

1. A data converter comprising:
a control element (34) that produces a control signal (36) in response to a digital input;
an operational amplifier (14) having a first input node, a second input node and an output node producing an analog output signal;
a first reference input element (18) that provides a first temperature variant signal to the first input node, the state of the first temperature variant signal being based on the control signal; and
a second reference input element (22) that provides a second temperature variant signal to the first input node, the state of the second temperature variant signal being based on the control signal;
wherein the combination of the first and second temperature variant signals at the first input node results in the analog output signal being a function of the digital input and being substantially temperature invariant.

2. The data converter of claim 1, wherein the first and second reference input elements comprise switched capacitors controlled at least partially by at least one clock signal.

3. The data converter of claim 1, further comprising a voltage reference circuit (40) producing a plurality of reference signals.

4. The data converter of claim 3, wherein the plurality of reference signals include a first reference signal, a second reference signal and a third reference signal, wherein the first reference input element samples the first reference signal and the second reference input element samples a difference between the second and third reference signals.

5. The data converter of claim 1, wherein the first temperature variant signal and the second temperature variant signal have complementary voltage variation as a function of temperature.

6. The data converter of claim 1, wherein the first reference input element comprises a capacitor (50) connected to a first switch (42), a second switch (44), a third switch (46), and a fourth switch (48), wherein the first and second switches are controlled by the control signal and sample the first temperature variant signal on the capacitor.

7. A method of controlling a data converter comprising the steps of:
(a) coupling a digital signal to a control element that produces a control signal based on the digital signal;
(b) coupling, based on the control signal, a first temperature variant signal to a first input node of an operational amplifier;
(c) coupling, based on the control signal, a second temperature variant signal to the first input node of the operational amplifier; and
(d) generating an analog output signal at an output of the operational amplifier in response to the combination of the first and second temperature variant signals at the first input node, resulting in the analog output signal being a function of the digital input and being substantially temperature invariant.

8. The method of claim 7, further comprising the step of coupling a first reference signal to a first reference input element, and further comprising sampling, at the first reference input element, the first reference signal.

9. The method of claim 7, further comprising the step of coupling a second reference signal and a third reference signal to a second reference input element, and further comprising the step of sampling, at the second sampling reference input element, a difference between the second and third reference signals.

10. The method of claim 7, wherein the first temperature variant signal and the second temperature variant signal have complementary voltage variation as a function of temperature.
